# FASCICULE DE BREVET EUROPEEN

(11) **EP 1 431 243 B1**
(45) Date de publication et mention de la délivrance du brevet: **23.08.2006**
(21) Numéro de dépôt: 03354091.5
(22) Date de dépôt: 12.12.2003
(51) Int. Cl.: B81B 7/00

(54) **Composant d'encapsulation de micro-systèmes électromécaniques intégrés et procédé de réalisation du composant**
Vorrichtung zur Verkapselung von mikroelektromechanischen integrierten Systemen und Verfahren zu deren Herstellung
Device for the encapsulation of integrated microelectromechanical systems and method for its manufacture

(30) Priorité: 20.12.2002 FR 0216274
(43) Date de publication de la demande: 23.06.2004
(73) Titulaire: COMMISSARIAT A L'ENERGIE ATOMIQUE, 75752 Paris Cédex 15 (FR)
(72) Inventeur: Delapierre, Gilles, 38180 Seyssins (FR)
(74) Mandataire: Jouvray, Marie-Andrée

(56) Documents cités:
- EP-A- 1 070 677
- EP-A- 1 071 126
- EP-A- 1 167 281
- WO-A-01/29529

## Description

### Domaine technique de l'invention

L'invention concerne un composant d'encapsulation de micro-systèmes électromécaniques intégrés dans une cavité, comportant un substrat, dans lequel est formée la cavité, un capot présentant une face avant et une face arrière, disposée sur le substrat, et des moyens de scellement du capot sur le substrat destinés à rendre la cavité étanche.

### État de la technique

La technologie des micro-systèmes électromécaniques intégrés (« MEMS : micro electro-mechanical systems ») a connu un développement considérable au cours des dernières années. Les applications les plus connues sont les accéléromètres pour airbag, les gyromètres pour navigation et les commutateurs radiofréquence et optiques pour les télécoms.

Afin de réduire les coûts de fabrication, on cherche à appliquer de façon toujours plus poussée le principe de fabrication collective, sur lequel repose toute la puissance des micro-technologies. Ainsi, on cherche à fabriquer des puces les plus petites possibles pour en avoir le plus grand nombre possible sur un même substrat.

La fabrication collective est d'autant plus intéressante si elle comporte toutes les étapes de la fabrication. Cependant, souvent certaines étapes de la fabrication sont effectuées collectivement, tandis que d'autres étapes sont effectuées individuellement sur chaque puce. L'étape de scellement par exemple est très coûteuse si elle est réalisée au niveau de la puce individuelle après découpe du substrat.

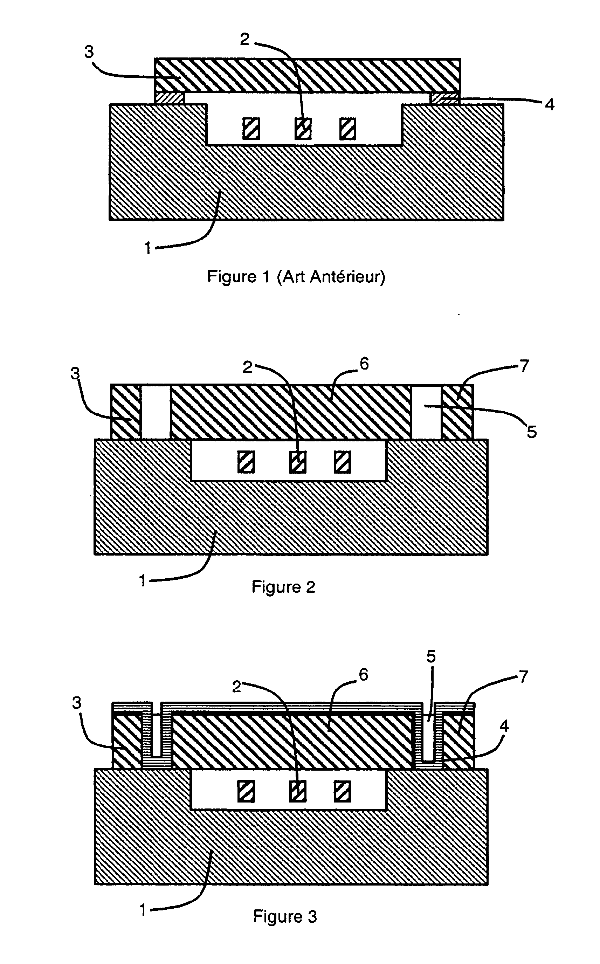

Comme représenté sur la figure 1, un MEMS actuel est typiquement constitué d'un substrat 1 et de micro-systèmes électromécaniques 2 intégrés dans une cavité du substrat 1. Afin de protéger les micro-systèmes, un capot 3 est fixé sur le substrat 1 par des moyens de scellement 4 destinés à rendre la cavité étanche.

On cherche à développer des procédés qui soient à la fois :
- collectifs sur tranche,
- peu consommateurs de surface de silicium (pour réduire la taille des puces),
- capables de garantir une très bonne herméticité de longue durée et dans des environnements sévères de température et d'humidité,
- peu générateurs de contraintes parasites,
- flexibles au niveau de la conception du MEMS lui-même,
- de préférence réalisables à basse température ( < 450°C).

Aucune des techniques connues à ce jour ne permet de satisfaire en même temps à toutes ces conditions.

Une première technique connue consiste à sceller un capot par un cordon de matériau polymère. L'intérêt de cette solution est que la forme du cordon peut être définie par des techniques de photolithographie, qui permettent de réaliser des cordons de très petite largeur (quelques dizaines de micromètres), peu consommateurs de surface de puce. Le scellement peut de plus être effectué par des moyens simples à basse température. L'inconvénient majeur est qu'il est impossible de garantir, avec un polymère, une très bonne herméticité, notamment au vide. Les polymères résistent d'autre part mal aux agressions de l'environnement.

Une deuxième technique, très utilisée aujourd'hui, consiste à utiliser un cordon de verre fusible déposé par sérigraphie. On trouve des verres fusibles à 450°C et cette technique assure une bonne herméticité. Elle présente cependant l'inconvénient important de conduire à des cordons de très grande largeur (quelques centaines de micromètres), ce qui devient inacceptable pour les produits de grande diffusion. Par exemple, la surface des puces pour capteur d'accélération de la prochaine génération sera de l'ordre du millimètre au carré. Or, la largeur du cordon est liée à la technique de dépôt de la pâte de verre par sérigraphie et il est donc difficile d'espérer réduire cette largeur.

Une troisième technique, plus intégrée, consiste à remplacer le capot par une couche mince déposée. Le déroulement typique d'un procédé de ce type comporte un dépôt d'une couche sacrificielle, le dépôt de la couche mince servant de capot et l'enlèvement de la couche sacrificielle. La couche capot est souvent en silicium polycristallin, matériau quelquefois utilisé également pour le MEMS lui-même. Cette technique représente l'intérêt d'une très grande miniaturisation et donc d'un coût potentiel très bas. Elle utilise un scellement minéral, donc hermétique. Un inconvénient important est cependant que le capot doit être déposé avant que la couche sacrificielle de libération mécanique du MEMS ne soit gravée. La couche capot ne peut en effet pas être déposée en l'air. L'attaque de libération du capot doit donc se faire à travers des trous dans le capot, ce qui est très compliqué et demande une conception très particulière du MEMS. Cette contrainte réduit fortement la liberté de conception du MEMS lui-même. Un autre inconvénient est la faible épaisseur du capot (quelques micromètres), qui dans certains cas peut se déformer sous l'effet de la pression extérieure.

Le document EP 1 167 281 A2 décrit un capot pour MEMS qui est scellé au substrat du MEMS par liaison des matériaux métalliques.

### Objet de l'invention

L'invention a pour but de remédier à ces inconvénients et, plus particulièrement, de proposer un procédé de fabrication de micro-systèmes électromécaniques intégrés minimisant les problèmes de fabrication collective, d'encombrement, d'herméticité, de dilatation thermique et de solidité du capot tout en réduisant les contraintes de conception du MEMS et le coût de fabrication.

Selon l'invention, ce but est atteint par le fait que le capot comporte au moins une rainure traversant le capot et délimitant dans le capot une zone périphérique et une zone centrale, recouvrant totalement la cavité, un matériau de scellement étant disposé au fond de la rainure.

L'invention a également pour objet un procédé de réalisation d'un composant dans lequel le scellement est réalisé par :
- une première étape, de creusement dans le capot d'au moins une rainure traversant le capot et délimitant dans le capot une zone centrale et une zone périphérique,
- une seconde étape, de mise en contact du substrat et du capot, de manière à ce que la zone centrale recouvre totalement une cavité du substrat,
- une troisième étape, de scellement par dépôt d'un matériau de scellement au fond de la rainure.

Selon un autre procédé de réalisation d'un composant selon l'invention, le scellement est réalisé par :
- une première étape, de creusement dans la face avant du capot (3) d'au moins une rainure (9) ayant une profondeur inférieure à l'épaisseur du capot (3) et délimitant dans le capot (3) une zone centrale (6) et une zone périphérique (7),
- une seconde étape, de remplissage au moins partiel de la rainure (9) par de la poudre de verre et fusion du verre (4),
- une troisième étape, d'enlèvement d'une épaisseur suffisante de la face arrière du capot (3), pour découvrir le verre contenu dans la rainure (9),
- une quatrième étape, de mise en contact du substrat (1) et du capot (3) de manière à ce que la zone centrale (6) recouvre totalement la cavité du substrat, et de scellement par fusion du verre (4).

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente une vue en coupe d'un composant comportant des micro-systèmes électromécaniques intégrés selon l'art antérieur.
Les figures 2 et 3 représentent deux étapes d'un mode particulier de réalisation d'un procédé selon l'invention.
Les figures 4 et 5 représentent un mode de réalisation particulier d'un capot selon l'invention respectivement en vue de dessous et en vue de dessus.
Les figures 6 et 7 représentent deux étapes d'un mode particulier de réalisation d'un procédé selon l'invention, permettant une connexion du substrat.
La figure 8 est une représentation d'un mode particulier de réalisation d'un composant selon l'invention, dans lequel le capot comporte une cavité.
La figure 9 est une représentation d'un mode particulier de réalisation d'un composant selon l'invention, dans lequel le capot comporte une couche isolante.
Les figures 10 à 13 représentent différentes étapes d'un mode particulier de réalisation d'un procédé selon l'invention.
La figure 14 est une représentation d'un mode particulier de réalisation d'un composant selon l'invention, dans lequel le capot comporte un sillon.

### Description de modes particuliers de réalisation.

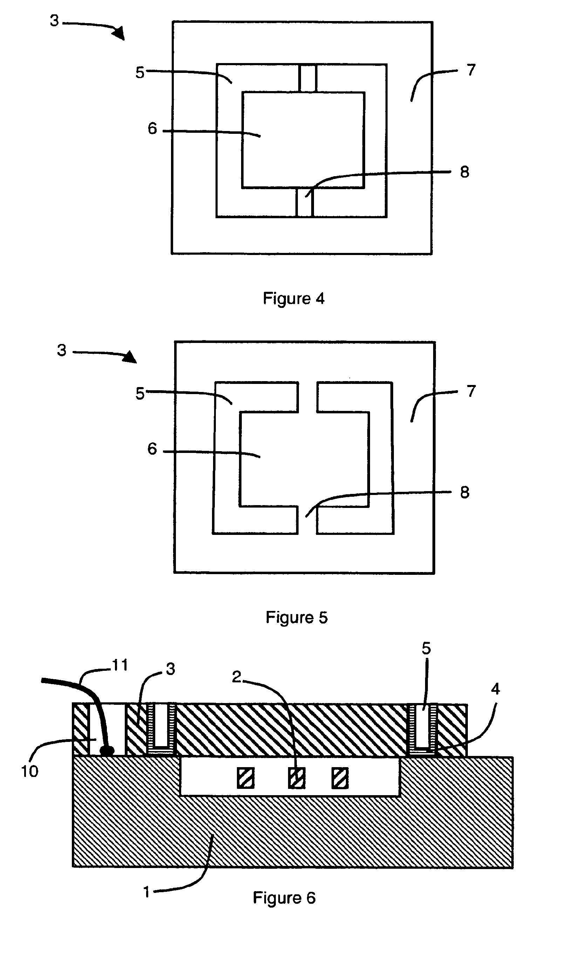

La figure 2 représente un composant comportant un substrat 1 et des micro-systèmes électromécaniques 2 intégrés dans une cavité à la face supérieure du substrat 1. Le capot 3, disposé avec sa face arrière sur le substrat 1, comporte au moins une rainure 5, par exemple annulaire, traversant le capot 3 et délimitant dans le capot 3 une zone périphérique 7 et une zone centrale 6, recouvrant totalement la cavité.

Pour rendre la cavité étanche, un matériau de scellement 4 est disposé au moins au fond de la rainure 5. Sur la figure 3, une couche de matériau de scellement 4 est déposée sur la face avant du capot 3, recouvrant la totalité de cette face avant, les parois et le fond de la rainure 5. Le capot 3 peut comporter des rainures supplémentaires (non-représentées) dans la zone centrale 6, permettant de réaliser des scellements supplémentaires sur des socles disposés dans la cavité vis-à-vis de la rainure supplémentaire.

La rainure 5 n'est pas nécessairement annulaire. Elle peut avoir des périmètres internes et externes carrés, circulaires ou d'une forme plus complexe, l'essentiel étant que la rainure forme une boucle fermée, pour que le matériau de scellement 4 entoure complètement la cavité, afin d'obtenir l'étanchéité.

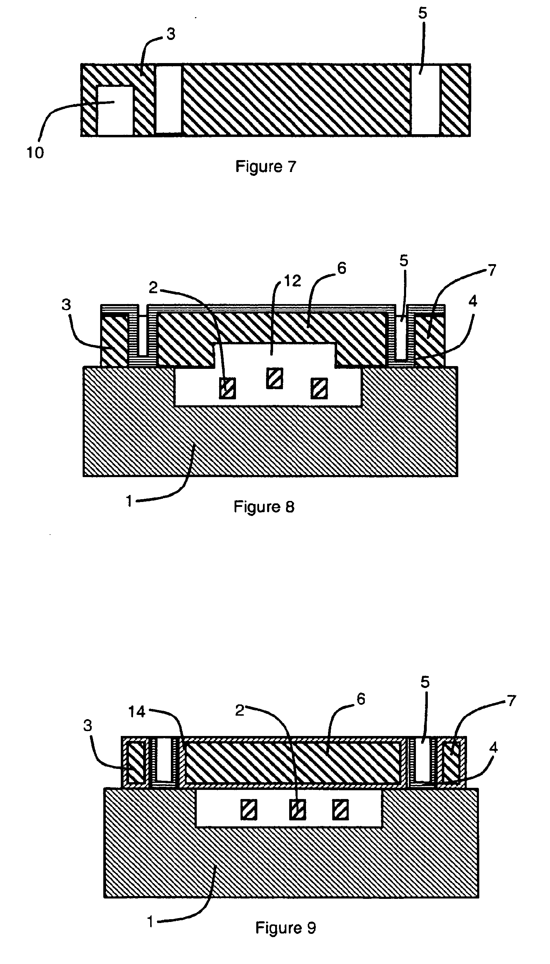

Les figures 4 et 5 représentent une rainure dont les périmètres interne et externe sont carrés. La zone centrale 6 peut être reliée à la zone périphérique 7, à la face avant du capot, par des bras 8 solidaires du capot. Ces bras peuvent être obtenus en gravant des rainures non-débouchantes sur la face arrière du capot, puis par une gravure de la face arrière pour délimiter la forme des bras 8. Ainsi, à la face arrière du capot, la rainure 5 forme une boucle complète (figure 4), tandis qu'à la face avant cette boucle est interrompue par les bras 8 (figure 5).

Le matériau de scellement 4 peut être minéral, métallique ou isolant. Un scellement peut aussi comporter plusieurs couches de matériaux différents. Les principaux procédés utilisables pour l'introduction du matériau de scellement 4 dans les rainures 5 sont le dépôt par vapeur chimique (« CVD : chemical vapor deposition ») et le dépôt d'une couche de verre fusible.

L'évaporation sous vide est également envisageable. Sa directivité complique cependant le procédé de dépôt du fait d'effets d'ombrage et il est alors nécessaire de faire varier l'orientation des substrats en cours de dépôt (utilisation bien connue de planétaires) pour que toutes les zones utiles soient couvertes.

Le matériau de scellement déposé par CVD peut être choisi parmi les matériaux les plus classiques des procédés de la microélectronique : oxyde de silicium, nitrure de silicium, polysilicium, tungstène, etc... Parmi tous les procédés de type CVD, le dépôt par vapeur chimique à basse pression (« LPCVD : low pressure chemical vapor deposition ») est particulièrement adapté, parce qu'il présente un bon pouvoir couvrant dans les rainures. Il peut cependant nécessiter des températures élevées qui, dans certains cas, ne sont pas acceptables. Une variante possible à basse température est un procédé plasma à base de tétraéthoxysilane (« PETEOS CVD : plasma enhanced tetra-ethyl-ortho-silicate chemical vapor deposition ») qui offre un bon compromis entre qualité de couche, conformité de la couche au substrat et température de dépôt ( en dessous de 450°C).

Au moment du scellement, le substrat 1 et le capot 3 doivent être suffisamment proches l'un de l'autre (quelques micromètres) pour que la couche déposée assure l'étanchéité. On peut à cet effet appliquer une tension électrique entre le substrat 1 et le capot 3 pour les mettre en contact par des forces électrostatiques.

Comme représenté à la figure 6, la zone périphérique 7 du capot 3 peut comporter au moins un orifice 10 traversant le capot 3 et par lequel passe un fil 11 de connexion électrique au substrat 1. Pour éviter, que l'orifice 10 ne soit bouché pendant le dépôt du matériau de scellement 4, un orifice 10 d'une profondeur inférieure à l'épaisseur initiale du capot 3 peut être usiné dans la face arrière du capot 3 (figure 7). Ainsi, pendant le dépôt du matériau de scellement, l'orifice 10 est protégé par le capot 3. Après le dépôt, le capot 3 est aminci sur sa face avant de manière à découvrir l'orifice 10. Le fil 11 de connexion au substrat peut ensuite être mis en place.

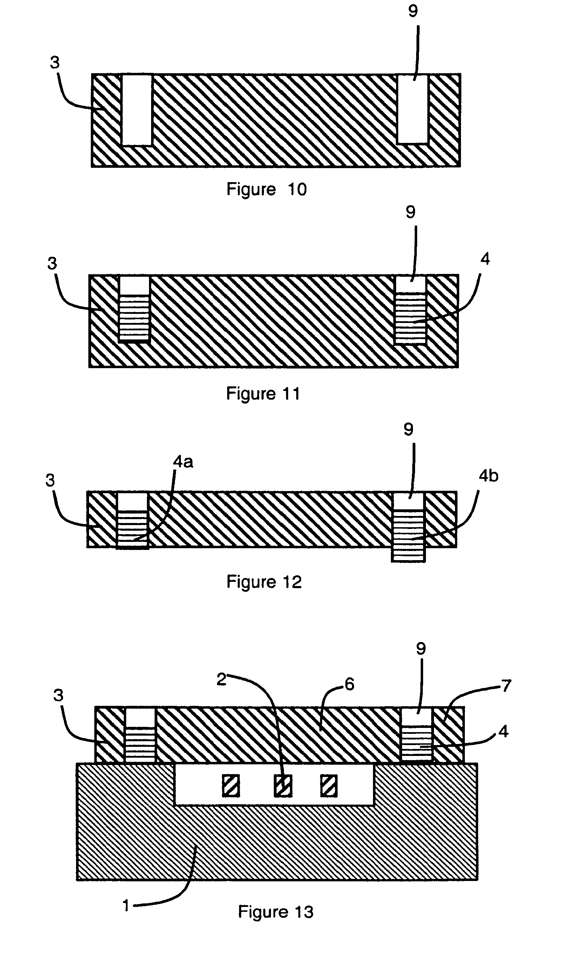

La figure 8 montre un mode de réalisation particulier, dans lequel la zone centrale 6 du capot 3 comporte une cavité supplémentaire 12 à la face arrière du capot, permettant d'augmenter l'espace utile des micro-systèmes électromécaniques 2 intégrés.

Comme représenté à la figure 9, le capot 3 peut comprendre une couche isolante 14 dans les rainures 5 et sur les faces avant et arrière, de façon à isoler électriquement le capot 5 du matériau de scellement 4. La couche isolante 14 peut être déposée autour des zones centrale 6 et périphérique 7 du capot après le creusement des rainures 5. Un moyen connu pour réaliser la couche isolante 14 est une oxydation thermique du capot 3. Le matériau de scellement 4, s'il est électriquement conducteur, peut alors servir d'interconnexion électrique entre le substrat 1 et des éléments disposés sur le capot 3.

Le scellement d'un composant selon la figure 3 est illustré sur les figures 2 et 3. Une première étape consiste à creuser dans le capot 3 au moins une rainure 5 traversant le capot 3 et délimitant dans le capot 3 une zone centrale 6 et une zone périphérique 7, comme représenté à la figure 2. L'usinage des rainures de la largeur du scellement souhaitée s'effectue, de manière connue, typiquement par gravure ionique réactive du matériau du capot, typiquement du silicium. Une seconde étape consiste à mettre en contact le substrat 1 et le capot 3, de manière à ce que la zone centrale 6 soit disposée en regard de la cavité du substrat, de manière à la recouvrir totalement, comme représenté à la figure 2. Puis, dans une troisième étape, représentée à la figure 3, le matériau de scellement 4 est déposé au moins au fond de la rainure 5. Ensuite les différentes puces sont découpées.

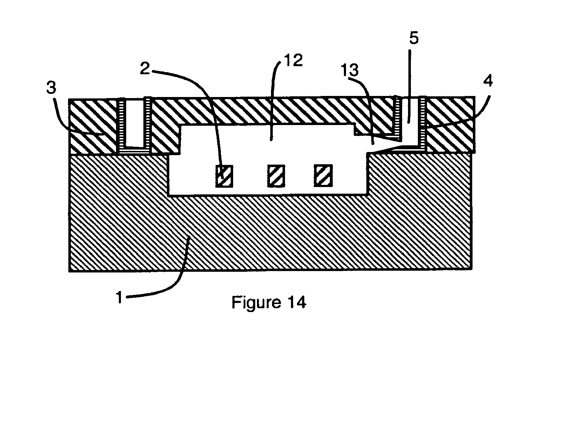

Dans le cas d'un scellement en verre fusible, un autre procédé de réalisation peut être envisagé, représenté aux figures 10 à 13. Une première étape consiste alors à creuser dans la face avant du capot 3 au moins une rainure 9 ayant une profondeur inférieure à l'épaisseur du capot 3. Le capot doit donc avoir une épaisseur supérieure à l'épaisseur finale souhaitée. Ensuite, comme représenté à la figure 11, la rainure 9 est remplit au moins partiellement par de la poudre de verre et le verre est chauffé pour faire fondre le verre 4 dans la rainure 9. Une troisième étape, représentée à la figure 12, consiste à enlever de la face arrière du capot 3, une épaisseur suffisante pour découvrir le verre (4a) contenu dans la rainure 9. Puis, dans une quatrième étape, représentée à la figure 13, le substrat 1 et le capot 3 sont mis en contact et l'étape de scellement est effectuée par fusion du verre 4. Dans cette variante de procédé, une étape supplémentaire peut consister dans la gravure sélective de la face arrière du capot 3 entre les troisième et quatrième étapes de manière à ce que le verre 4 contenu dans la rainure fasse saillie comme représenté en 4b. Lors de l'étape de scellement, cette partie en saillie s'étale sur une largeur légèrement supérieure à la largeur de la rainure 5.

On peut également combiner le dépôt CVD et le verre fusible, une première couche mince étant déposée par CVD pour assurer un minimum de tenue mécanique et le verre fusible étant introduit ensuite dans les rainures pour parfaire l'étanchéité.

La figure 14 représente un composant avec un capot comportant un sillon 13 entre une cavité 12 et une rainure 5. Le sillon 13 est creusé dans la face arrière du capot 3 avant l'étape de mise en contact du substrat 1 et du capot 3. Ainsi, lors du dépôt du scellement (par CVD par exemple), le sillon empêche localement le bouchage complet, de manière à laisser un passage entre la cavité et la rainure. Ceci permet un bouchage ultérieur sous atmosphère contrôlée.

Dans un autre procédé de réalisation, on rajoute une étape de creusement d'un trou dans le capot 3, permettant également un bouchage ultérieur sous atmosphère contrôlée. Le bouchage peut être effectué par tous moyens connus tels que scellement d'un substrat additionnel, fusion d'une bille en étain et plomb ou de verre fusible.

## Revendications

1. Composant d'encapsulation de micro-systèmes électromécaniques (2) intégrés dans une cavité, comportant un substrat (1), dans lequel est formée la cavité, un capot (3) présentant une face avant et une face arrière, disposée sur le substrat (1), et des moyens de scellement (4) du capot (3) sur le substrat (1) destinés à rendre la cavité étanche, composant **caractérisé en ce que** le capot (3) comporte au moins une rainure (5) traversant le capot (3) et délimitant dans le capot (3) une zone périphérique (7) et une zone centrale (6) recouvrant totalement la cavité, un matériau de scellement (4) étant disposé au fond de la rainure (5).

2. Composant d'encapsulation selon la revendication 1, **caractérisé en ce que** la zone centrale (6) est reliée à la zone périphérique (7), à la face avant du capot (3), par des bras (8) solidaires du capot (3).

3. Composant d'encapsulation selon l'une des revendications 1 et 2, **caractérisé en ce que** le capot (3) comporte au moins une rainure supplémentaire dans la zone centrale (6).

4. Composant d'encapsulation selon l'une quelconque des revendications 1 à 3, **caractérisé en ce que** la zone périphérique (7) du capot (3) comporte au moins un orifice (10) traversant le capot (3) par lequel passe un fil (11) de connexion électrique au substrat (1).

5. Composant d'encapsulation selon l'une quelconque des revendications 1 à 4, **caractérisé en ce que** le matériau de scellement (4) comporte une couche de verre fusible.

6. Composant d'encapsulation selon l'une quelconque des revendications 1 à 5, **caractérisé en ce que** le capot (3) comporte une couche isolante disposée dans les rainures (5), de manière à isoler électriquement le matériau de scellement (4) du capot (3).

7. Composant d'encapsulation selon l'une quelconque des revendications 1 à 6, **caractérisé en ce que** la zone centrale (6) du capot (3) comporte au moins une cavité supplémentaire (12) à la face arrière du capot.

8. Procédé de réalisation d'un composant d'encapsulation selon l'une quelconque des revendications 1 à 7, **caractérisé en ce qu'**il comporte:
- une première étape, de creusement dans le capot (3) d'au moins une rainure (5) traversant le capot (3) et délimitant dans le capot (3) une zone centrale (6) et une zone périphérique (7),
- une seconde étape, de mise en contact du substrat (1) et du capot (3), de manière à ce que la zone centrale (6) recouvre totalement une cavité du substrat,
- une troisième étape, de scellement par dépôt d'un matériau de scellement au fond de la rainure (5).

9. Procédé de réalisation selon la revendication 8, **caractérisé en ce que** le dépôt du matériau de scellement (4) comporte le dépôt d'une couche mince.

10. Procédé de réalisation selon la revendication 9, **caractérisé en ce que** le dépôt de la couche mince est réalisé par un procédé de type CVD.

11. Procédé de réalisation d'un composant d'encapsulation selon l'une quelconque des revendications 1 à 7, **caractérisé en ce qu'**il comporte:
- une première étape, de creusement dans la face avant du capot (3) d'au moins une rainure (9) ayant une profondeur inférieure à l'épaisseur du capot (3) et délimitant dans le capot (3) une zone centrale (6) et une zone périphérique (7),
- une seconde étape, de remplissage au moins partiel de la rainure (9) par de la poudre de verre et fusion du verre (4),
- une troisième étape, d'enlèvement d'une épaisseur suffisante de la face arrière du capot (3) pour découvrir le verre contenu dans la rainure (9),
- une quatrième étape, de mise en contact du substrat (1) et du capot (3) de manière à ce que la zone centrale (6) recouvre totalement la cavité du substrat, et de scellement par fusion du verre (4).

12. Procédé de réalisation selon la revendication 11, **caractérisé en ce qu'**il comporte une étape de gravure sélective de la face arrière du capot (3) entre les troisième et quatrième étapes de manière à ce que le verre (4) contenu dans la rainure fasse saillie (4b).

13. Procédé de réalisation selon l'une quelconque des revendications 8 à 12, **caractérisé en ce que** la mise en contact du substrat (1) et du capot (3) est effectuée par application d'une tension électrique entre le substrat (1) et le capot (3).

14. Procédé de réalisation selon l'une quelconque des revendications 8 à 13, **caractérisé en ce qu'**il comporte, dans la première étape, l'usinage, dans la face arrière du capot (3), d'un orifice (10) d'une profondeur inférieure à l'épaisseur du capot (3), et une étape d'amincissement de la face avant du capot (3) après l'étape de scellement.

15. Procédé de réalisation selon l'une quelconque des revendications 8 à 14, **caractérisé en ce qu'**il comporte, avant l'étape de mise en contact du substrat (1) et du capot (3), une étape de creusement d'un sillon (13) dans la face arrière du capot (3), empêchant localement un bouchage complet par le matériau de scellement (4) pendant l'étape de scellement, permettant un bouchage ultérieur sous atmosphère contrôlée.

16. Procédé de réalisation selon l'une quelconque des revendications 8 à 15, **caractérisé en ce qu'**il comporte une étape de creusement d'un trou dans le capot (3), permettant un bouchage ultérieur sous atmosphère contrôlée.

## Claims

1. A component for encapsulation of micro electromechanical systems (2) integrated in a cavity, comprising a substrate (1) wherein the cavity is formed, a cover (3) presenting a front face and a rear face, arranged on the substrate (1), and means (4) for sealing the cover (3) onto the substrate (1) designed to make the cavity hermetic, component wherein the cover (3) comprises at least one groove (5) passing through the cover (3) and defining in the cover (3) a peripheral zone (7) and a central zone (6) completely covering the cavity, a sealing material (4) being deposited at the bottom of the groove (5).

2. Encapsulation component according to claim 1, **characterized in that** the central zone (6) is joined to the peripheral zone (7), on the front face of the cover (3), by arms (8) securely fixed to the cover (3).

3. Encapsulation component according to any one of claims 1 or 2, **characterized in that** the cover (3) comprises at least one additional groove in the central zone (6).

4. Encapsulation component according to any one of claims 1 to 3, **characterized in that** the peripheral zone (7) of the cover (3) comprises at least one hole (10) passing through the cover (3) through which hole a wire (11) passes for electrical connection to the substrate (1).

5. Encapsulation component according to any one of claims 1 to 4, **characterized in that** the sealing material (4) comprises a layer of molten glass.

6. Encapsulation component according to any one of claims 1 to 5, **characterized in that** the cover (3) comprises an insulating layer deposited in the grooves (5) so as to electrically insulate the sealing material (4) from the cover (3).

7. Encapsulation component according to any one of claims 1 to 6, **characterized in that** the central zone (6) of the cover (3) comprises at least one additional cavity (12) on the rear face of the cover.

8. A fabrication process of an encapsulation component according to any one of claims 1 to 7, **characterized in that** it comprises:
- a first stage of making in the cover (3) at least one groove (5) passing through the cover (3) and defining a central zone (6) and a peripheral zone (7) in the cover (3),
- a second stage of bringing the substrate (1) and cover (3) into contact so that the central zone (6) completely covers a cavity of the substrate,
- a third stage of sealing by depositing a sealing material at the bottom of the groove (5).

9. Fabrication process according to claim 8, **characterized in that** deposition of the sealing material (4) comprises deposition of a thin film.

10. Fabrication process according to claim 9, **characterized in that** deposition of the thin film is performed by a CVD process.

11. Fabrication process of an encapsulation component according to any one of claims 1 to 7, **characterized in that** it comprises :
- a first stage of making in the front face of the cover (3) at least one groove (9) having a depth smaller than the thickness of the cover (3) and defining a central zone (6) and a peripheral zone (7) in the cover (3),
- a second stage of at least partial filling of the groove (9) with glass powder and melting of the glass (4),
- a third stage of removing a sufficient thickness from the rear face of the cover (3) to uncover the glass contained in the groove (9),
- a fourth stage of bringing the substrate (1) and cover (3) into contact so that the central zone (6) completely covers the cavity of the substrate, and of sealing by melting of the glass (4).

12. Fabrication process according to claim 11, **characterized in that** it comprises a selective etching stage of the rear face of the cover (3) between the third and fourth stages so that the glass (4) contained in the groove is salient (4b).

13. Fabrication process according to any one of claims 8 to 12, **characterized in that** bringing the substrate (1) and cover (3) into contact is achieved by applying an electrical voltage between the substrate (1) and cover (3).

14. Fabrication process according to any one of claims 8 to 13, **characterized in that** it comprises, in the first stage, machining, in the rear face of the cover (3), of a hole (10) having a depth smaller than the thickness of the cover (3), and a stage of thinning the front face of the cover (3) after the sealing stage.

15. Fabrication process according to any one of claims 8 to 14, **characterized in that** it comprises, before the stage of bringing the substrate (1) and cover (3) into contact, a stage of making a channel (13) in the rear face of the cover (3) locally preventing complete plugging by the sealing material (4) during the sealing stage, enabling subsequent sealing in a controlled atmosphere.

16. Fabrication process according to any one of claims 8 to 15, **characterized in that** it comprises a stage of making a hole in the cover (3) enabling subsequent sealing in a controlled atmosphere.

## Patentansprüche

1. Bauteil zum Umhüllen elektr-omechanischer Mikrosysteme (2) in ein Gehäuse, die in einen Hohlraum integriert sind, das ein Substrat (1) umfasst, in dem der Hohlraum gebildet ist, sowie einen Deckel (3), der eine Vorderseite und eine Rückseite aufweist, die auf dem Substrat (1) angeordnet ist, sowie Mittel (4) zum Versiegeln des Deckels (3) auf dem Substrat (1), die vorgesehen sind, den Hohlraum dicht zu machen, ein Bauteil, das **dadurch gekennzeichnet ist, dass** der Deckel (3) mindestens eine Rille (5) umfasst, die durch den Deckel (3) hindurchführt und in dem Deckel (3) einen Randbereich (7) und einen zentralen Bereich (6) begrenzt, der den Hohlraum komplett bedeckt, wobei am Boden der Rille (5) ein Versiegelungsmaterial (4) angeordnet ist.

2. Bauteil zum Umhüllen nach Anspruch 1, **dadurch gekennzeichnet, dass** der zentrale Bereich (6) mit dem Randbereich (7) an der Vorderseite des Deckels (3) durch Arme (8) verbunden ist, die fest mit dem Deckel (3) verbunden sind.

3. Bauteil zum Umhüllen nach einem der Ansprüche 1 und 2, **dadurch gekennzeichnet, dass** der Deckel (3) mindestens eine zusätzliche Rille im zentralen Bereich (6) umfasst.

4. Bauteil zum Umhüllen nach einem der Ansprüche 1 bis 3, **dadurch gekennzeichnet, dass** der Randbereich (7) des Deckels (3) mindestens eine durch den Deckel (3) führende Öffnung (10) aufweist, durch die ein Draht (11) zur elektrischen Verbindung mit dem Substrat (1) geführt ist.

5. Bauteil zum Umhüllen nach einem der Ansprüche 1 bis 4, **dadurch gekennzeichnet, dass** das Versiegelungsmaterial (4) eine Schicht aus schmelzbarem Glas umfasst.

6. Bauteil zum Umhüllen nach einem der Ansprüche 1 bis 5, **dadurch gekennzeichnet, dass** der Deckel (3) eine isolierende Schicht aufweist, die in den Rillen (5) angeordnet ist, um das Versiegelungsmaterial (4) elektrisch vom Deckel (3) zu isolieren.

7. Bauteil zum Umhüllen nach einem der Ansprüche 1 bis 6, **dadurch gekennzeichnet, dass** der zentrale Bereich (6) des Deckels (3) auf der Rückseite des Deckels mindestens einen zusätzlichen Hohlraum (12) umfasst.

8. Verfahren zur Herstellung eines Bauteils zum Umhüllen nach einem der Ansprüche 1 bis 7, **dadurch gekennzeichnet, dass** es umfasst:
- einen ersten Schritt zum Herstellen mindestens einer durch den Deckel (3) geführten Rille (5) im Deckel (3), die in dem Deckel (3) einen zentralen Bereich (6) und einen Randbereich (7) begrenzt,
- einen zweiten Schritt, bei dem das Substrat (1) mit dem Deckel (3) in Kontakt gebracht wird, damit der zentrale Bereich (6) einen Hohlraum des Substrats vollkommen bedeckt,
- einen dritten Schritt, zur Versiegelung, bei dem ein Versiegelungsmaterial am Boden der Rille (5) aufgebracht wird.

9. Herstellungsverfahren nach Anspruch 8, **dadurch gekennzeichnet, dass** das Aufbringen des Versiegelungsmaterials (4) das Aufbringen einer dünnen Schicht einschließt.

10. Herstellungsverfahren nach Anspruch 9, **dadurch gekennzeichnet, dass** das Aufbringen der dünnen Schicht mittels eines Verfahrens der Art CVD-Verfahren erfolgt.

11. Verfahren zur Herstellung eines Bauteils zum Umhüllen nach einem der Ansprüche 1 bis 7, **dadurch gekennzeichnet, dass** es umfasst:
- einen ersten Schritt, bei dem in der Vorderseite des Deckels (3) mindestens eine Rille (9) hergestellt wird, deren Tiefe geringer ist als die Dicke des Deckels (3), und die in dem Deckel (3) einen zentralen Bereich (6) und einen Randbereich (7) begrenzt,
- einen zweiten Schritt, in dem die Rille (9) zumindest teilweise mit Glaspulver gefüllt wird und das Glas (4) geschmolzen wird,
- einen dritten Schritt, bei dem eine ausreichende Dicke aus der Rückseite des Deckels (3) entfemt wird, um das in der Rille (9) enthaltene Glas freizulegen,
- einen vierten Schritt, bei dem das Substrat (1) mit dem Deckel (3) so in Kontakt gebracht wird, dass der zentrale Bereich (6) den Hohlraum des Substrats vollkommen bedeckt, und bei dem durch Schmelzen des Glases (4) eine Versiegelung erfolgt.

12. Herstellungsverfahren nach Anspruch 11, **dadurch gekennzeichnet, dass** es eine selektive Ätzung der Rückseite des Deckels (3) zwischen dem dritten und vierten Schritt umfasst, damit das in der Rille enthaltene Glas (4) herausragt (4b).

13. Herstellungsverfahren nach einem der Ansprüche 8 bis 12, **dadurch gekennzeichnet, dass** das Substrat (1) und der Deckel (3) durch Anlegen einer elektrischen Spannung zwischen Substrat (1) und Deckel (3) miteinander in Kontakt gebracht werden.

14. Herstellungsverfahren nach einem der Ansprüche 8 bis 13, **dadurch gekennzeichnet, dass** es im ersten Schritt die Herstellung einer Öffnung (10) in der Rückseite des Deckels (3) umfasst, deren Tiefe geringer ist als die Dicke des Deckels (3) sowie einen Schritt der Verringerung der Vorderseite des Deckels (3) nach dem Versiegelungsschritt.

15. Herstellungsverfahren nach einem der Ansprüche 8 bis 14, **dadurch gekennzeichnet, dass** es vor dem Schritt, bei dem das Substrat (1) und der Deckel (3) miteinander in Kontakt gebracht werden, einen Arbeitsschritt des Herstellens einer Kerbe (13) in der Rückseite des Deckels (3) umfasst, die örtlich ein vollständiges Verstopfen durch das Versiegelungsmaterial (4) während des Versiegelungsvorgangs verhindert und ein späteres Verschließen in kontrollierter Atmosphäre erlaubt.

16. Herstellungsverfahren nach einem der Ansprüche 8 bis 15, **dadurch gekennzeichnet, dass** es einen Schritt zur Herstellung eines Loches in dem Deckel (3) umfasst, der ein späteres Verschließen in kontrollierter Atmosphäre ermöglicht.
